# FASCICULE DE BREVET EUROPEEN

(11) **EP 1 466 031 B1**
(45) Date de publication et mention de la délivrance du brevet: **17.11.2010**
(21) Numéro de dépôt: 03712238.9
(22) Date de dépôt: 14.01.2003
(51) Int. Cl.: C23C 16/04, C23C 16/455, C04B 41/45

(54) **PROCEDE ET INSTALLATION POUR LA DENSIFICATION DE SUBSTRATS PAR INFILTRATION CHIMIQUE EN PHASE VAPEUR**
VERFAHREN UND VORRICHTUNG ZUR VERDICHTUNG VON SUBSTRATEN MITTELS CHEMISCHER GASPHASENINFILTRATION
METHOD AND INSTALLATION FOR THE DENSIFICATION OF SUBSTRATES BY MEANS OF CHEMICAL VAPOUR INFILTRATION

(30) Priorité: 15.01.2002 FR 0200412
(43) Date de publication de la demande: 13.10.2004
(73) Titulaire: Snecma Propulsion Solide, Société Anonyme, 33187 Le Haillan Cedex (FR)
(72) Inventeur: BERNARD, Bruno, Toctoucau, 3 33600 Pessac (FR); GOUJARD, Stéphane, F-33700 Merignac (FR); BERTRAND, Sébastien, F-33480 Moulis-en-Médoc (FR)
(74) Mandataire: Joly, Jean-Jacques
(86) Numéro de dépôt international: PCT/FR2003/000097
(87) Numéro de publication internationale: WO 2003/060183

(56) Documents cités:
- WO-A-99/04059
- FR-A- 2 754 813
- US-A- 2 729 190
- US-A- 4 580 524
- US-B2- 6 402 849

## Description

Procédé et installation pour la densification de substrats par infiltration chimique en phase vapeur.

### Arrière-plan de l'invention

L'invention concerne les techniques d'infiltration chimique en phase vapeur. Le domaine d'application de l'invention est la densification de substrats poreux, en particulier la réalisation de pièces en matériau composite par densification de substrats fibreux par une matrice.

De façon classique, un procédé de densification de substrats par infiltration chimique en phase vapeur comprend les étapes de chargement de substrats poreux à densifier dans une zone de chargement d'une enceinte, le chauffage du volume interne de l'enceinte, l'introduction d'un gaz réactif dans l'enceinte à travers une entrée située à une extrémité de celle-ci, et le préchauffage du gaz réactif après son entrée dans l'enceinte et avant sa venue au contact des pièces situées dans la zone de chargement.

La température et la pression régnant dans l'enceinte sont choisies pour permettre au gaz réactif de diffuser au sein de la porosité des substrats et d'y déposer le matériau constitutif de la matrice par décomposition d'un ou plusieurs composants du gaz réactif ou par réaction entre plusieurs composants.

Le préchauffage du gaz réactif est habituellement réalisé par passage du gaz à travers une zone de préchauffage située dans l'enceinte et dans laquelle s'ouvre l'entrée de gaz réactif. Une zone de préchauffage classique comprend une pluralité de plateaux perforés disposés les uns au-dessus des autres et portés à la température interne de l'enceinte.

Le préchauffage du gaz réactif a pour but d'amener celui-ci, dès son entrée dans la zone de chargement, à une température la plus proche possible de celle requise pour la formation de la matrice souhaitée. En effet, alors que la température de réaction est typiquement de l'ordre de 1000°C pour la formation de matrice en carbone pyrolytique ou en céramique, une température de gaz réactif inférieure de quelques dizaines de °C seulement à la température souhaitée peut affecter de façon significative la cinétique de densification et la microstructure du matériau de matrice déposé.

Cela a été observé dans le cas notamment de la densification de substrats disposés en piles, en particulier de substrats de forme annulaire destinés à la réalisation de disques de frein en matériau composite. Des procédés et installations pour la densification de substrats annulaires en piles sont décrits dans les documents US 5 904 957 et EP 0 792 385. Le gaz réactif issu de la zone de préchauffage est admis dans le volume interne des piles qui sont formées par les substrats annulaires superposés et qui s'étendent verticalement dans la zone de chargement au-dessus de la zone de préchauffage, l'entrée du gaz réactif se situant à la base de l'enceinte. Un gradient de densification est observé entre les substrats situés au bas des piles et les autres substrats, gradient d'autant plus important que le préchauffage du gaz réactif est insuffisant.

Ce problème pourrait être résolu en accroissant le volume de la zone de préchauffage. Toutefois, pour un volume total d'enceinte donné, cela affecterait l'espace disponible pour le chargement des substrats. Or, les processus de densification par infiltration chimique en phase vapeur sont longs et coûteux à réaliser, de sorte que les capacités de chargement des installations doivent être optimales.

En outre, le gaz réactif parvenant au sommet des piles a parcouru celles-ci sur toute leur hauteur et a subi une maturation, de sorte que les substrats situés en haut des piles reçoivent un gaz réactif dont la composition peut être différente de celle du gaz réactif à son entrée dans la zone de chargement. Il peut là aussi en résulter des caractéristiques de densification différentes.

### Objet et résumé de l'invention

L'invention a pour but de fournir un procédé qui permet d'améliorer la distribution et le préchauffage du gaz réactif et, d'une façon générale, de réduire les gradients de densification entre substrats situés en des emplacements différents de la zone de chargement, et ce sans affecter la capacité de chargement, voire même en l'augmentant.

Ce but est atteint grâce à un procédé tel que défini en tête de la description et dans lequel le préchauffage du gaz réactif admis dans l'enceinte est réalisé au moins en partie par passage dans un conduit raccordé à l'entrée de gaz, s'étendant à travers la zone de chargement et porté à la température interne de l'enceinte, et le gaz réactif préchauffé est distribué dans la zone de chargement à travers une ou plusieurs ouvertures formées dans la paroi latérale du conduit, le long de celui-ci.

Ainsi, le conduit assure à la fois le préchauffage du gaz réactif et sa distribution dans la zone de chargement.

La distribution du gaz réactif peut être réalisée à travers une ou plusieurs fentes s'étendant longitudinalement à travers la paroi latérale du conduit.

En variante, le gaz réactif peut être distribué dans l'enceinte à travers une pluralité de perçages formés dans la paroi latérale du conduit.

Afin de favoriser le préchauffage, le gaz réactif circule dans le conduit avantageusement au contact de parois formant surfaces d'échange de chaleur et s'étendant à l'intérieur du conduit.

Dans le cas de la densification de substrats annulaires disposés dans la zone de chargement en au moins une pile verticale, le gaz réactif admis dans l'enceinte est avantageusement préchauffé et distribué par passage dans un conduit s'étendant verticalement à l'intérieur de la pile.

La distribution du gaz réactif est alors de préférence réalisée uniquement à travers des ouvertures formées dans la paroi latérale du conduit.

L'invention a aussi pour objet de fournir une installation permettant la mise en oeuvre du procédé défini ci-avant.

Ce but est atteint grâce à une installation comportant une enceinte à l'intérieur de laquelle se trouve une zone de chargement de substrats à densifier, un suscepteur délimitant l'enceinte et associé à des moyens de chauffage de l'enceinte, une entrée de gaz réactif à une extrémité de l'enceinte, et des moyens de préchauffage du gaz réactif situés dans l'enceinte, installation dans laquelle un conduit est raccordé à l'entrée de gaz réactif dans l'enceinte et s'étend à travers la zone de chargement, le conduit étant muni sur sa longueur d'ouvertures latérales qui s'ouvrent dans la zone de chargement afin d'y distribuer le gaz réactif.

Selon un mode de réalisation, les ouvertures sont sous forme d'au moins une fente longitudinale. La paroi du tube peut alors être formée d'une pluralité de panneaux ménageant entre eux des espaces longitudinaux.

Selon un autre mode de réalisation, les ouvertures sont sous forme de perçages répartis le long du conduit.

Avantageusement, des parois sont disposées à l'intérieur du conduit. Ces parois internes peuvent être sous forme de panneaux longitudinaux ménageant entre eux des espaces.

### Brève description des dessins

L'invention sera mieux comprise à la lecture de la description faite ci-après, à titre indicatif mais non limitatif, en référence aux dessins annexés, sur lesquels :
- la figure 1 est une vue schématique en élévation et en coupe montrant une installation de densification par infiltration chimique en phase vapeur selon un mode de réalisation de l'invention ;
- la figure 2 est une vue en coupe transversale partielle, à échelle agrandie, montrant plus particulièrement le conduit de préchauffage et distribution de gaz réactif de l'installation de la figure 1 ;
- la figure 3 est une vue en coupe transversale montrant une variante de réalisation du conduit de préchauffage et distribution de gaz réactif ;
- la figure 4 est une vue schématique en élévation et en coupe montrant un mode de réalisation d'une installation de densification par infiltration chimique en phase vapeur, selon l'art antérieur ;
- la figure 5 est une vue en élévation montrant un autre mode de réalisation d'un conduit de préchauffage et distribution de gaz réactif ;
- la figure 6 est une vue en coupe transversale du conduit de la figure 5 ;
- la figure 7 est une vue schématique en élévation et en coupe montrant une installation de densification par infiltration chimique en phase vapeur selon un autre mode de réalisation de l'invention ; et
- les figures 8 et 9 sont des vues schématiques en élévation et en coupe illustrant d'autres applications d'une installation conforme à l'invention.

### Description détaillée de modes de réalisation

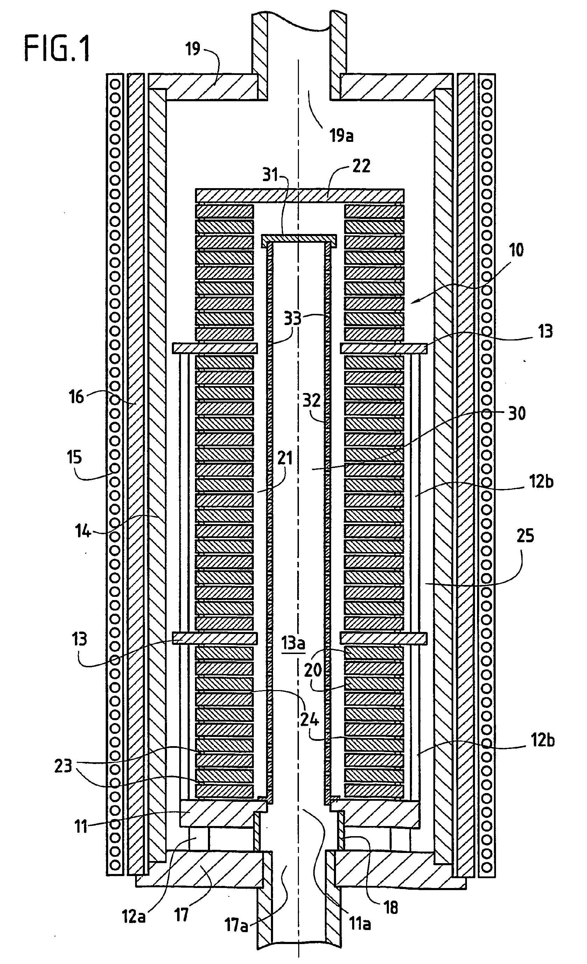

La figure 1 montre schématiquement une enceinte 10 contenant un chargement de substrats poreux 20. Les substrats 20 sont par exemple des préformes en fibres de carbone ou des ébauches formées de préformes pré-densifiées, lesquelles préformes ou ébauches sont destinées à la réalisation de disques de frein en matériau composite carbone/carbone (C/C), par densification par une matrice en carbone pyrolytique.

Le chargement est sous forme d'une pile de substrats délimitant un volume interne 21 formé par les passages centraux des substrats alignés verticalement. La pile est portée par un plateau support inférieur 11 reposant sur des pieds 12a. Elle peut être formée de plusieurs sections superposées séparées par un ou plusieurs plateaux de supports intermédiaires 13. Le plateau 11 est muni d'une ouverture 11a qui est alignée axialement avec les passages centraux des substrats 20 et avec des ouvertures 13a des plateaux intermédiaires 13. A son sommet, la pile de substrats est munie d'un couvercle 22 obturant le volume interne 21. Les plateaux 13 sont supportés par le plateau support 11 par l'intermédiaire de colonnes ou chandelles 12b.

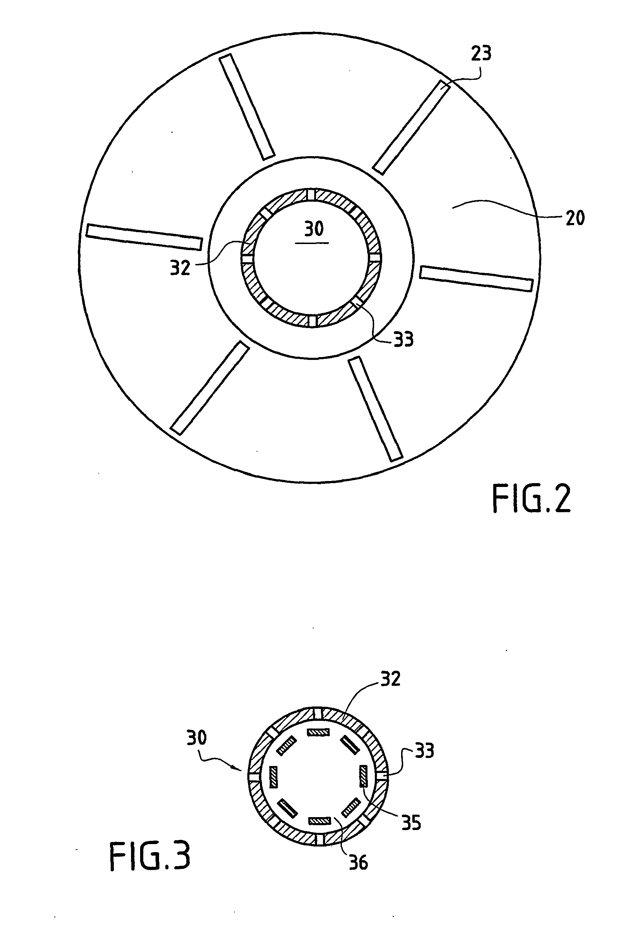

Chaque substrat 20 est séparé d'un substrat adjacent et, le cas échéant, d'un plateau 11 ou 13 ou du couvercle 22 par une ou plusieurs cales d'espacement 23 qui définissent des intervalles 24 (figures 1 et 2). Les cales 23, par exemple disposées radialement, sont aménagées pour former des passages faisant communiquer le volume interne 21 avec le volume externe 25 situé à l'extérieur de la pile, dans l'enceinte.

Les passages ménagés par les cales 23 pourront être dimensionnés de manière à permettre un équilibrage de la pression entre les volumes 21 et 25, comme décrit dans le document US 5 904 957. En variante, il pourra s'agir de passages de fuite offrant une section de passage restreinte de manière à permettre l'existence d'un gradient de pression entre les volumes 21 et 25, comme décrit dans la demande de brevet FR 01 03 004.

L'enceinte est chauffée au moyen d'un suscepteur 14 qui délimite latéralement l'enceinte. Le suscepteur constitue par exemple un induit qui est couplé inductivement avec un inducteur 15. L'inducteur 15 entoure l'enceinte en étant séparé de l'induit 14 par une paroi 16 formant isolant thermique. En variante, le chauffage du suscepteur peut être réalisé par des résistances électriques couplées thermiquement avec le suscepteur.

Un gaz réactif contenant un ou plusieurs constituants précurseurs de carbone est introduit dans l'enceinte à travers une ouverture 17a formée dans le fond 17 de l'enceinte. Les précurseurs sont des composés gazeux hydrocarbonés, typiquement du méthane, du propane, ou un mélange des deux. Dans l'intervalle entre le fond 17 et le plateau 12, le gaz réactif est canalisé par une paroi cylindrique 18 reliant les ouvertures 17a et 11a.

Un conduit tubulaire vertical 30 se raccorde à son extrémité inférieure à l'ouverture 11a et s'étend verticalement à l'intérieur du volume 21, jusqu'au voisinage immédiat du sommet de la pile de substrats. A son extrémité supérieure, le conduit 30 est obturé par un couvercle 31. Le conduit 30 peut être formé de plusieurs sections raccordées bout à bout permettant une construction modulaire.

Dans l'exemple illustré par les figures 1 et 2, le conduit 30 a sa paroi latérale 32 munie d'une pluralité d'ouvertures 33 en forme de perçages qui sont réparties à la fois sur la longueur du conduit 30 et autour de l'axe de celui-ci.

Ainsi, le gaz réactif admis dans l'enceinte est distribué dans le volume interne 21 par passage à travers les ouvertures 33 du conduit 30 et passe du volume 21 au volume 25 en diffusant à travers les substrats 20 et en passant à travers les passages ménagés par les cales d'espacement 23. Le gaz résiduel est extrait de l'enceinte 10 à travers une ouverture 19a qui est formée dans le couvercle 19 de l'enceinte et qui est reliée à des moyens d'aspiration (non représentés).

Le conduit 30 assure non seulement la distribution du gaz réactif sur toute la hauteur de la pile, mais aussi le préchauffage de ce gaz, le conduit 30 étant porté à la température régnant dans l'enceinte.

Afin d'améliorer le préchauffage, des parois internes d'échange de chaleur peuvent être disposées à l'intérieur du conduit 30. Dans le mode de réalisation de la figure 3, ces parois internes sont sous forme de panneaux longitudinaux 35 répartis autour de l'axe du conduit et ménageant entre eux des intervalles 36.

Le conduit 30, le couvercle 31 et les parois internes éventuelles 35 sont par exemple en graphite. D'autres matériaux sont utilisables, par exemple un matériau composite C/C. Les parois 14, 17, 19 de l'enceinte 10 sont avantageusement en graphite. Les plateaux 11, 13, couvercle 22, cales d'espacement 23 et paroi 18 sont par exemple en graphite ou en matériau composite C/C.

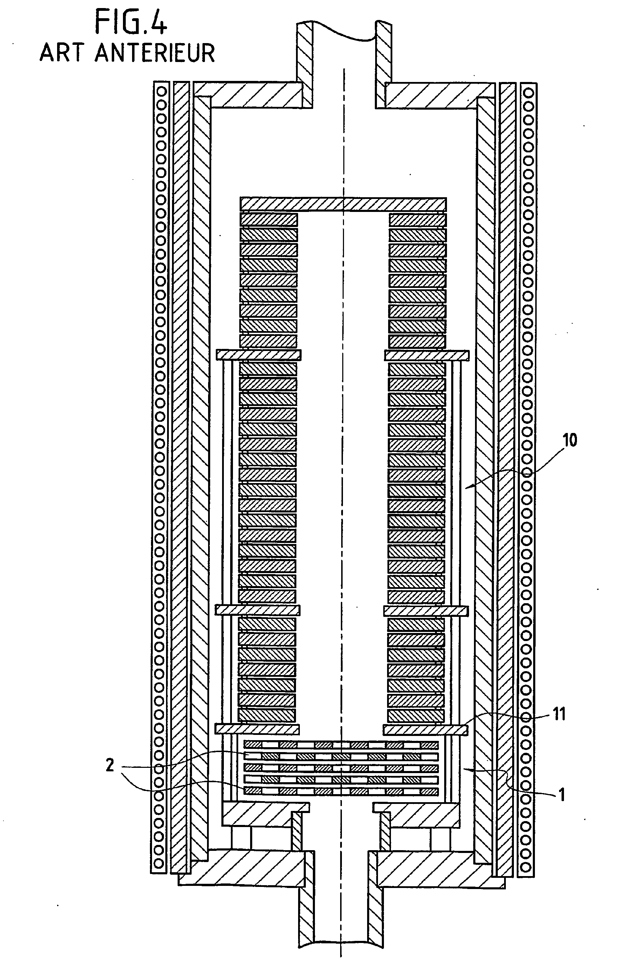

En comparaison avec une installation de l'art antérieur comportant une zone de préchauffage 1 entre l'entrée de gaz réactif et le plateau 11 sur lequel repose la pile (voir figure 4), l'installation des figures 1 et 2, qui est dépourvue de zone de préchauffage, offre une capacité de chargement sensiblement augmentée. En effet, la zone de chargement de l'enceinte 10, qui s'étend au-dessus du plateau 11, est plus grande que celle de l'installation de la figure 4, la zone de préchauffage avec des plateaux perforés 2 situés les uns au-dessus des autres, occupant une place relativement importante.

On notera toutefois que la présence d'une zone de préchauffage, qui peut être restreinte par rapport à celles des installations de l'art antérieur, est possible dans le cadre de l'invention.

Le conduit 30 doit avoir un diamètre suffisant pour pouvoir offrir une surface d'échange thermique importante, tout en restant espacé des substrats 20 empilés.

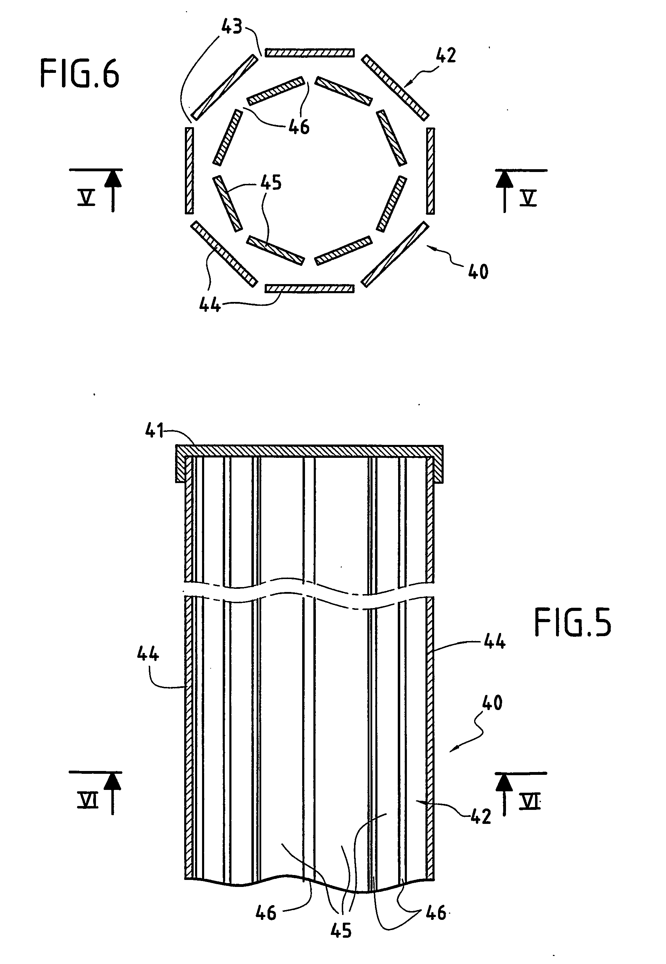

Les figures 5 et 6 illustrent une variante de réalisation d'un conduit 40 de préchauffage et répartition de gaz réactif pouvant être substitué au conduit 30 de l'installation des figures 1 et 2.

La paroi latérale 42 du conduit 40 présente des ouvertures 43 sous forme de fentes longitudinales qui s'étendent sur la longueur du conduit, celui-ci étant obturé par un couvercle 41 à sa partie supérieure. Dans l'exemple illustré, les fentes 43 sont rectilignes et réparties régulièrement autour de l'axe du conduit 40.

Les fentes 43 sont formées par des intervalles entre des panneaux longitudinaux 44 qui constituent la paroi latérale 42 du conduit 40. Des parois internes supplémentaires d'échange de chaleur sont disposées dans le conduit 40. Comme dans le mode de réalisation de la figure 3, ces parois internes sont sous forme de panneaux longitudinaux 45 répartis autour de l'axe du conduit et ménageant entre eux des intervalles 46. Les panneaux 45 et 44 sont disposés en quinconce autour de l'axe du conduit 40 de sorte qu'un intervalle 46 débouche sur un panneau 44, entre deux fentes 43.

Bien entendu, les fentes pourront suivre des trajets autres que rectilignes, par exemple hélicoïdaux, entre le bas et le haut du conduit.

D'une façon générale, on pourra conférer toutes formes aux ouvertures ménagées dans la paroi latérale du conduit, par exemple des formes oblongues ou de lumières allongées s'étendant axialement, circonférentiellement ou de façon oblique.

Dans le mode de réalisation des figures 1 et 2, une seule pile de substrats 20 est représentée. En variante, plusieurs piles de substrats pourront être disposées côte à côte dans l'enceinte. Dans ce cas, un conduit de préchauffage et de répartition de gaz réactif est disposé dans chaque pile et est relié à une entrée commune de gaz réactif ou, de préférence, à une entrée particulière alignée avec le conduit.

On notera encore que le sens de circulation du gaz réactif peut être inversé, avec une entrée de gaz formée dans le couvercle de l'enceinte et une sortie formée dans le fond espacé du plateau supportant la pile dont le passage central est alors obturé à la partie inférieure.

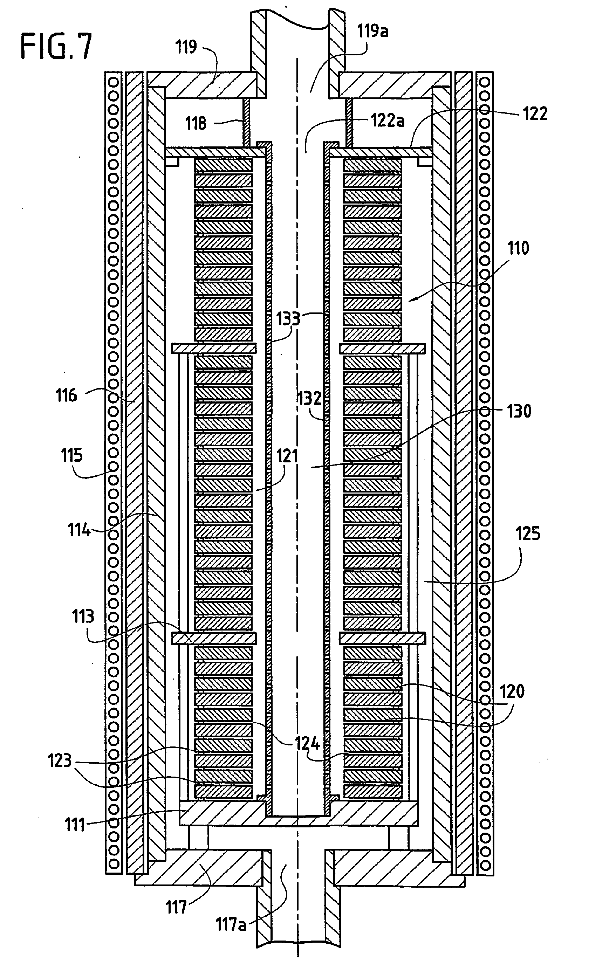

Comme montré par la figure 7, et de la même façon que montré par la figure 1, la pile de substrats annulaires 120 est logée dans une enceinte 110 délimitée latéralement par un suscepteur 114 formant induit couplé inductivement avec un inducteur 115, avec interposition d'un isolant 116. La pile de substrats 120 est formée de plusieurs sections superposées séparées par un ou plusieurs plateaux intermédiaires 113 et repose sur le plateau inférieur 111 qui ne présente pas d'ouverture centrale, afin de fermer la pile.

A son sommet, la pile est surmontée par un couvercle 122 muni d'une ouverture centrale 122a alignée axialement avec le volume interne 121 de la pile.

Entre son entrée dans l'enceinte 110 à travers le couvercle 119 et l'ouverture centrale 122a, le gaz réactif admis est canalisé par une paroi cylindrique 118 qui peut éventuellement entourer une zone de préchauffage restreint du gaz.

Un conduit tubulaire vertical 130 se raccorde à son extrémité supérieure à l'ouverture 122a et s'étend jusqu'au plateau 111 qui obture le conduit à son extrémité inférieure. Le conduit 130 peut être semblable au conduit 30 ou au conduit 40 décrits plus haut. Dans l'exemple illustré, le conduit 130 a la paroi 132 munie d'une pluralité d'ouvertures 133 réparties sur la longueur et autour de l'axe du conduit.

Le gaz réactif admis dans l'enceinte est distribué dans le volume interne 121 de la pile de substrats par passage à travers les ouvertures 133. Le gaz passe du volume 121 au volume 125 extérieur à la pile en diffusant à travers les substrats 120 et en passant à travers des passages ménagés par des cales interposées entre les substrats. Le gaz résiduel est extrait de l'enceinte à travers l'ouverture centrale 117a du fond 117 de l'enceinte.

Pour le reste, l'installation est semblable à celle de la figure 1.

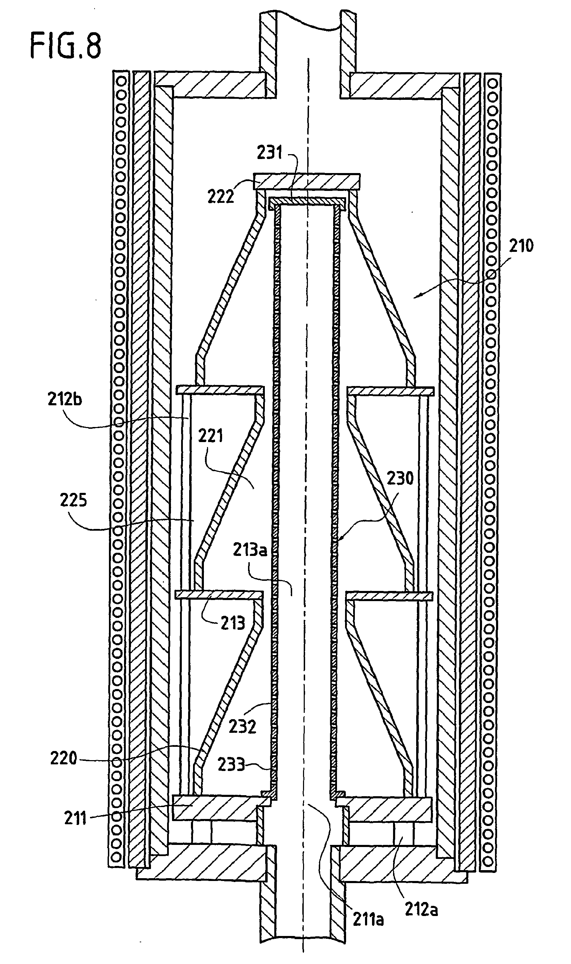

Le procédé et l'installation conformes à l'invention peuvent être utilisés pour la densification de substrats poreux autres que des préformes de disques de frein, par exemple pour des substrats constituant des préformes 220 de divergents de moteurs fusées, comme montré par la figure 8.

Plusieurs substrats 220 sont disposés dans la même zone de chargement d'une enceinte 210 avec leurs passages axiaux alignés verticalement. Le substrat en partie inférieure est porté par un plateau 211 qui repose sur des pieds 212a, tandis que les autres substrats reposent sur des plateaux intermédiaires annulaires 213. Les plateaux 213 sont supportés par le plateau support 211 par des colonnes ou chandelles 212b.

Les volumes internes des substrats 220 forment, avec les ouvertures centrales 213a des plateaux 213, le volume interne 221 de la pile de substrats. Le volume 221 est obturé par un couvercle 222 à sa partie supérieure. Des cales 223 sont interposées entre les extrémités axiales des substrats 220 et les plateaux 211, 213 et peuvent ainsi aménager des passages faisant communiquer le volume 221 avec le volume 225 extérieur aux substrats dans l'enceinte.

Un conduit 230 de préchauffage et répartition de gaz réactif est raccordé à une extrémité inférieure à une ouverture centrale 211a du plateau 211. Le conduit 230 s'étend verticalement dans le volume 221 jusqu'à proximité immédiate du sommet de la pile de substrats, où le conduit 230 est fermé par un couvercle 231.

Le conduit 230 a sa paroi latérale 232 munie d'ouvertures 233, par exemple en forme de perçages, le conduit 230 étant du même type que celui 30 du mode de réalisation des figures 1 et 2.

Pour le reste, l'installation est identique au mode de réalisation des figures 1 et 2.

Le domaine d'application de l'invention n'est pas limité à la densification de substrats de forme annulaire ou de forme axisymétrique creuse.

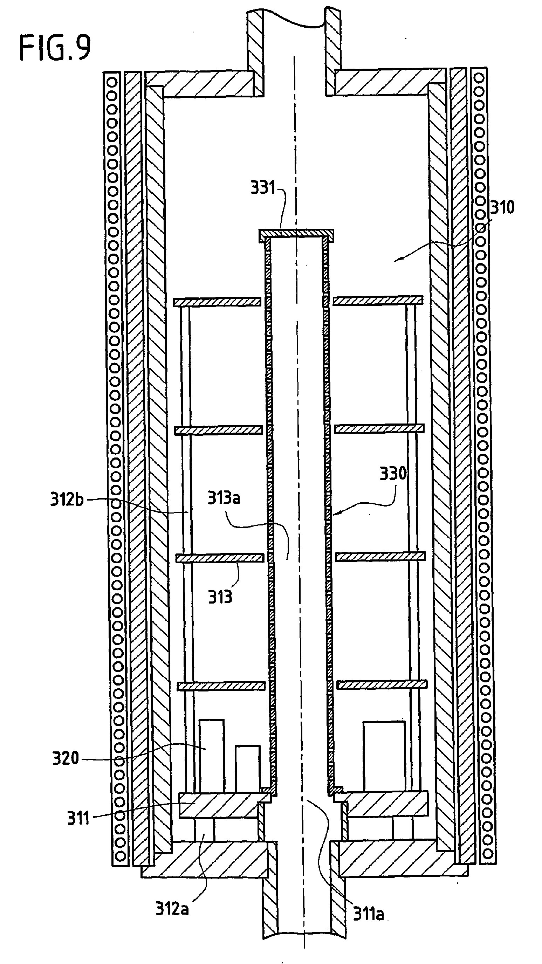

Ainsi, la figure 9 montre une enceinte 310 avec un plateau support inférieur 311 et plusieurs plateaux supports intermédiaires 313 dans une zone de chargement de l'enceinte 310. Les plateaux 311 et 313 sont munis d'ouvertures centrales, respectivement 311a et 313a alignées avec une entrée de gaz réactif dans l'enceinte.

Un conduit vertical 330 de préchauffage et répartition de gaz réactif se raccorde à sa partie inférieure à l'ouverture 311a et s'étend verticalement à travers la zone de chargement de l'enceinte 310 en passant dans les ouvertures 313a. A son extrémité supérieure située au voisinage du sommet de la zone de chargement, le conduit 330 est obturé par un couvercle 331.

Les plateaux 311 et 313 sont supportés par des pieds 312a et des colonnes 312b.

Les plateaux 311, 313 supportent des substrats à densifier 320 (non tous représentés) qui peuvent être de diverses formes et dimensions.

Pour le reste, l'installation est identique à celle illustrée par les figures 1 et 2.

On notera que le procédé et l'installation conformes à l'invention peuvent être mis en oeuvre pour la densification de substrats poreux par des matrices autres que carbone pyrolytique, par exemple des matrices céramiques. Des processus d'infiltration chimique en phase vapeur de matériaux céramiques, par exemple de carbure de silicium (SiC) sont bien connus. La composition du gaz réactif est sélectionnée en fonction de la nature de matrice à déposer.

On notera aussi que la section de passage offerte par les ouvertures traversant la paroi latérale du conduit de préchauffage et de distribution pourra être uniformément répartie ou non sur toute la hauteur du conduit. Une répartition non uniforme peut notamment être adoptée lorsque les besoins en gaz réactif sont plus importants à certains niveaux du tube qu'à d'autres. Il peut en être ainsi lorsque la configuration du chargement des substrats et/ou les dimensions de ceux-ci varient sur la hauteur de la zone de chargement.

## Revendications

1. Procédé de densification de substrats poreux par infiltration chimique en phase vapeur comprenant le chargement de substrats poreux à densifier dans une zone de chargement d'une enceinte, le chauffage du volume interne de l'enceinte, l'introduction d'un gaz réactif dans l'enceinte à travers une entrée située à une extrémité de celle-ci, et le préchauffage du gaz réactif après son entrée dans l'enceinte et avant sa venue au contact des substrats situés dans la zone de chargement,
**caractérisé en ce que** le préchauffage du gaz réactif admis dans l'enceinte est réalisé au moins en partie par passage dans un conduit raccordé à l'entrée de gaz, s'étendant à travers la zone de chargement et porté à la température interne de l'enceinte, et le gaz réactif préchauffé est distribué dans la zone de chargement à travers une ou plusieurs ouvertures formées dans la paroi latérale du conduit, le long de celui-ci.

2. Procédé selon la revendication 1, **caractérisé en ce que** la distribution du gaz réactif est réalisée à travers une ou plusieurs fentes s'étendant longitudinalement à travers la paroi latérale du conduit.

3. Procédé selon la revendication 1, **caractérisé en ce que** la distribution du gaz réactif est réalisée à travers une pluralité de perçages formés dans la paroi latérale du conduit.

4. Procédé selon l'une quelconque des revendications 1 à 3, **caractérisé en ce que** le gaz réactif circule dans le conduit au contact de parois formant surfaces d'échange de chaleur et s'étendant à l'intérieur du conduit.

5. Procédé selon l'une quelconque des revendications 1 à 4 pour la densification de substrats annulaires disposés dans la zone de chargement en au moins une pile verticale, **caractérisé en ce que** le gaz réactif admis dans l'enceinte est préchauffé et est distribué dans l'enceinte par passage dans un conduit s'étendant verticalement à l'intérieur de la pile.

6. Procédé selon la revendication 5, **caractérisé en ce que** la distribution du gaz réactif est réalisée uniquement à travers des ouvertures formées dans la paroi latérale du conduit.

7. Installation de densification de substrats poreux par infiltration chimique en phase vapeur, comportant une enceinte à l'intérieur de laquelle se trouve une zone de chargement de substrats à densifier, un suscepteur délimitant l'enceinte et associé à des moyens de chauffage de l'enceinte, une entrée de gaz réactif à une extrémité de l'enceinte, et des moyens de préchauffage du gaz réactif situés dans l'enceinte,
**caractérisée en ce qu'**un conduit est raccordé à l'entrée de gaz réactif dans l'enceinte et s'étend à travers la zone de chargement, le conduit étant muni sur sa longueur d'ouvertures latérales qui s'ouvrent dans la zone de chargement afin d'y distribuer le gaz réactif.

8. Installation selon la revendication 7, **caractérisée en ce que** les ouvertures sont sous forme d'au moins une fente longitudinale.

9. Installation selon la revendication 8, **caractérisée en ce que** la paroi du tube est formée d'une pluralité de panneaux ménageant entre eux des espaces longitudinaux.

10. Installation selon la revendication 7, **caractérisée en ce que** les ouvertures sont sous forme de perçages répartis le long du conduit.

11. Installation selon l'une quelconque des revendications 8 à 10, **caractérisée en ce que** des parois sont disposées à l'intérieur du conduit.

12. Installation selon la revendication 11, **caractérisée en ce que** lesdites parois internes sont sous forme de panneaux longitudinaux ménageant entre eux des espaces.

## Claims

1. A method of densifying porous substrates by chemical vapor infiltration, the method comprising loading porous substrates for densification in a loading zone of an enclosure, heating the internal volume of the enclosure, introducing a reagent gas into the enclosure via an inlet situated at one end thereof, and preheating the reagent gas after it has entered into the enclosure and before it comes into contact with the substrates situated in the loading zone,
the method being **characterized in that** the reagent gas admitted into the enclosure is preheated, at least in part, by passing along a duct connected to the gas inlet and extending through the loading zone, the duct being raised to the temperature inside the enclosure, and the preheated reagent gas is distributed into the loading zone through one or more openings formed in the side wall of the duct, along the length thereof.

2. A method according to claim 1, **characterized in that** the reagent gas is distributed through one or more slots extending longitudinally through the side wall of the duct.

3. A method according to claim 1, **characterized in that** the reagent gas is distributed through a plurality of perforations formed through the side wall of the duct.

4. A method according to any one of claims 1 to 3, **characterized in that** the reagent gas flows along the duct in contact with walls forming heat exchange surfaces and extending inside the duct.

5. A method according to any one of claims 1 to 4 for densifying annular substrates disposed in the loading zone as at least one vertical stack, the method being **characterized in that** the reagent gas admitted into the enclosure is preheated and distributed inside the enclosure by passing along a duct extending vertically inside the stack.

6. A method according to claim 5, **characterized in that** the reagent gas is distributed solely via openings formed in the side wall of the duct.

7. An installation for densifying porous substrates by chemical vapor infiltration, the installation comprising an enclosure inside which there is a zone for loading substrates to be densified, a heater plate defining the enclosure and associated with means for heating the enclosure, a reagent gas inlet at one end of the enclosure, and means situated inside the enclosure for preheating the reagent gas,
the installation being **characterized in that** a duct is connected to the reagent gas inlet inside the enclosure and extends through the loading zone, the duct being provided along its length with lateral openings which open out into the loading zone in order to distribute the reagent gas therein.

8. An installation according to claim 7, **characterized in that** the openings are in the form of at least one longitudinal slot.

9. An installation according to claim 8, **characterized in that** the wall of the tube is formed by a plurality of panels leaving longitudinal gaps between one another.

10. An installation according to claim 7, **characterized in that** the openings are in the form of perforations distributed along the duct.

11. An installation according to any one of claims 8 to 10, **characterized in that** the walls are disposed inside the duct.

12. An installation according to claim 11, **characterized in that** said internal walls are in the form of longitudinal panels leaving spaces between one another.

## Patentansprüche

1. Verfahren zur Verdichtung von porösen Substraten mittels chemischer Gasphaseninfiltration, umfassend das Laden von zu verdichtenden porösen Substraten in einen Beschickungsbereich einer Kammer, das Erhitzen des Innenraums der Kammer, das Einleiten eines reaktiven Gases in die Kammer durch einen an einem Ende dieser befindlichen Einlaß sowie das Vorheizen des reaktiven Gases nach seinem Eintritt in die Kammer und vor seinem Inkontakttreten mit den in dem Beschickungsbereich befindlichen Substraten,
**dadurch gekennzeichnet, daß** das Vorheizen des in die Kammer eingeführten reaktiven Gases wenigstens teilweise durch Durchlaufen eines Rohrs erfolgt, das an den Gaseinlaß angeschlossen ist, durch den Beschickungsbereich verläuft und auf die Innentemperatur der Kammer erhitzt wird, und daß das vorgeheizte reaktive Gas durch eine oder mehrere Öffnungen, die in der Seitenwand des Rohrs, entlang diesem ausgebildet sind, in den Beschickungsbereich verteilt wird.

2. Verfahren nach Anspruch 1, **dadurch gekennzeichnet, daß** die Verteilung des reaktiven Gases durch einen oder mehrere Schlitze erfolgt, die sich in Längsrichtung durch die Seitenwand des Rohrs erstrecken.

3. Verfahren nach Anspruch 1, **dadurch gekennzeichnet, daß** die Verteilung des reaktiven Gases durch eine Vielzahl von in der Seitenwand des Rohrs ausgebildeten Bohrungen erfolgt.

4. Verfahren nach einem der Ansprüche 1 bis 3, **dadurch gekennzeichnet, daß** das reaktive Gas in dem Rohr in Kontakt mit Wänden zirkuliert, die Wärmeaustauschflächen bilden und sich innerhalb des Rohrs erstrecken.

5. Verfahren nach einem der Ansprüche 1 bis 4 für die Verdichtung von ringförmigen Substraten, die in dem Beschickungsbereich in Form wenigstens eines vertikalen Stapels angeordnet sind, **dadurch gekennzeichnet, daß** das in die Kammer eingeführte reaktive Gas vorgeheizt wird und durch Durchlaufen eines Rohrs, das senkrecht innerhalb des Stapels verläuft, in die Kammer verteilt wird.

6. Verfahren nach Anspruch 5, **dadurch gekennzeichnet, daß** die Verteilung des reaktiven Gases einzig durch in der Seitenwand des Rohrs ausgebildete Öffnungen erfolgt.

7. Einrichtung zum Verdichten von porösen Substraten mittels chemischer Gasphaseninfiltration, umfassend eine Kammer, in der sich ein Bereich zum Beladen mit zu verdichtenden Substraten befindet, einen Suszeptor, der die Kammer begrenzt und Mitteln zum Heizen der Kammer zugeordnet ist, einen Einlaß für reaktives Gas an einem Ende der Kammer sowie Mittel zum Vorheizen des reaktiven Gases, die sich in der Kammer befinden,
**dadurch gekennzeichnet, daß** ein Rohr an den Einlaß für reaktives Gas in der Kammer angeschlossen ist und durch den Beschickungsbereich verläuft, wobei das Rohr über seine Länge mit Seitenöffnungen versehen ist, die sich in den Beschickungsbereich öffnen, um das reaktive Gas hierin zu verteilen.

8. Einrichtung nach Anspruch 7, **dadurch gekennzeichnet, daß** die Öffnungen in Form wenigstens eines Längsschlitzes vorliegen.

9. Einrichtung nach Anspruch 8, **dadurch gekennzeichnet, daß** die Wand des Rohrs von einer Vielzahl von Platten gebildet ist, zwischen denen Längszwischenräume ausgespart sind.

10. Einrichtung nach Anspruch 7, **dadurch gekennzeichnet, daß** die Öffnungen in Form von entlang des Rohrs verteilten Bohrungen vorliegen.

11. Einrichtung nach einem der Ansprüche 8 bis 10, **dadurch gekennzeichnet, daß** Wände innerhalb des Rohrs angeordnet sind.

12. Einrichtung nach Anspruch 11, **dadurch gekennzeichnet, daß** die Innenwände in Form von Längsplatten vorliegen, zwischen denen Zwischenräume ausgespart sind.
